# EUROPEAN PATENT SPECIFICATION

(11) **EP 2 185 441 B1**
(45) Date of publication and mention of the grant of the patent: **14.03.2012**
(21) Application number: 07823900.1
(22) Date of filing: 18.09.2007
(51) Int. Cl.: B65D 75/32, B65D 75/36, H05K 13/00

(54) **ELECTRONIC COMPONENT PACKAGING**
KAPSELUNG ELEKTRONISCHER KOMPONENTEN
EMBALLAGE DE COMPOSANTS ELECTRONIQUES

(30) Priority: 08.08.2007 GB 0715503
(43) Date of publication of application: 19.05.2010
(73) Proprietor: Premier Farnell UK Limited, Leeds LS12 2QQ (GB)
(72) Inventor: NELISSEN, Frank, P., N., 5800 AA Venray (NL)
(74) Representative: McLean, Robert Andreas
(86) International application number: PCT/GB2007/003554
(87) International publication number: WO 2009/019411

(56) References cited:
- EP-A- 0 397 185
- WO-A-01/83331
- GB-A- 2 163 401
- US-A- 4 657 137
- US-A- 5 927 500

## Description

### BACKGROUND

### a. Field of the Invention

The present invention relates to the packaging of electronic components, including both passive and active electronic components and also static-sensitive electronic components.

### b. Related Art

Prior art document GB 2163401 A discloses an electronics component packaging system for use in a mass production environment where electronic components are packaged in a carrier tape having 2,000 to 5,000 recesses in a single row, each recess holding one electronic component The tape may be in a reel and has a covering tape that is peeled back to expose electronic components held by the carrier tape so that these components can be removed from the recesses and inserted by an automated inserting machine.

Electronic components, including discrete components such as resistors, capacitors and transistors and integrated components, in particular integrated circuits, are sometimes sold by retailers in relatively small quantities, for example in quantities of between one and one hundred. This may be because the sale is to a private individual making or repairing a single electronic device, or because the sale is to a company making a limited number of electronic components.

The retailer then has to pack and ship the electronic device(s) in such a way that the device is not damaged in any way physically or electronically. If the component is static sensitive, then the component must not be exposed to static electricity. If the device has delicate connection pins, then such pins must not be damaged. It will also, in general, be important to prevent external gaseous or liquid contaminants from entering the packaging, which can happen if the parcel carrying the electronic device(s) is not well cared for.

One known way in which one or more electronic components can be packaged is by using a box made from a plastic material incorporating an antistatic compound or coating, for example corrugated plastic containing an antistatic filler. To provide physical protection against jarring as well as further antistatic protection, the box is then lined, and optionally subdivided into a number of compartments, by antistatic foam layers or panels.

A worker packaging the electronic component(s), then manually places the component(s) inside one or more compartments within the box, and then seals the box for shipping. Often, the box will then be contained within an outer shipping container, for example a conventional cardboard box labelled with the recipient's address details.

When the recipient opens the parcel and the inner antistatic box, the electronic components should have arrived in good shape. Unfortunately, it is sometimes the case that components can be jarred against each other or the delicate legs of the components have been bent through inserting them into anti-static foam. Furthermore, all the components may be laid bare upon opening the inner box, even though the user may only require one such component at that time. The inner box may be re-sealable, but this still provides a potential way in which components not needed at that time may become damaged during the time the box is opened.

It would be desirable to provide a packaging system for electronic components which is more economical in use, less wasteful of packaging and therefore environmentally friendly, and which protects electronic components until such time as these are actually needed by a user.

It is therefore an object of the present invention to provide a more convenient and reliable way of packaging all types of electronic components which addresses these issues.

### SUMMARY OF THE INVENTION

According to the invention, there is provided an electronics packaging system for electronic components, comprising:
- a tray formed of plastic sheet material, said sheet having opposite first and second surfaces and having a plurality of individual recesses formed in the first surface thereof, each recess having a rim that extends around the recess and each recess being surrounded by a planar region of said first surface the rim (8) projecting above said region; and
- a coversheet of fabric which extends over said first surface of the tray and across the rims around said recesses, said coversheet being bonded to the tray to provide an individual packaging volume for an electronic device between each recess and said coversheet;
wherein said coversheet is bonded to the first surface at each rim, but not in at least a portion of said surrounding planar region.

The coversheet may optionally be an antistatic coversheet. Similarly, the plastic sheet material forming the tray may or may not have static sensitive or dissipative or conductive properties.

An advantage of this is that, in use, a user may more easily get between the un-bonded portion of the coversheet and peel off the bonded portion of the coversheet around the rim in order to gain access to the packaged electronic device.

Furthermore, the surrounding planar region may be provided with one or more lines of weakness so that a user can tear or break along these lines to separate one or more of the packaging volumes from one or more other packaging volumes. This helps a retailer or a user to quickly separate one or more of the individual packaging volumes.

The lines of weakness may include a perforation in at least the plastic sheet material, this perforation then not extending into the individual packaging volumes.

Alternatively, or additionally, these lines of weakness may include a local thinning in at least the plastic sheet material, this thinning not extending into the individual packaging volumes.

This helps to maintain isolation of the packaging volume from any liquid or gaseous contaminants in the external environment.

The system, in use, will package one or more electronic components held, preferably individually, within each packaging volume. Each chip may have projecting connection pins, which extend from the side of a body of the chip. These pins are then preferably seated within a groove provided in a base of the recess such that the pins extend away from the coversheet. The connection pins are then directed away from the coversheet so that these do not pierce the coversheet. The body of the chip may then be the only portion of the chip which can come into contact with the coversheet.

Each recess may include side walls, the groove in the recess extending around the base of the side walls, and these side walls having a clearance with the electronic device in the recess which maintains the seated location of the within the groove.

There will usually be a plurality of the individual packaging volumes. These volumes can then be arranged in a one-dimensional or two-dimensional array across the sheet material.

### BRIEF DESCRIPTION OF THE DRAWINGS

The invention will now be further described, by way of example only, and with reference to the accompanying drawings, in which:
Figure 1 shows a perspective view of an electronics packaging system according to a preferred embodiment of the invention, having an array of individual packaging volumes for electronic components;
Figure 2 is a plan view of the electronics packaging system of Figure 1;
Figure 3 is an end view of the electronics packaging system of Figure 1; and
Figure 4 is a cross-sectional view of the electronics packaging system, taken along line IV-IV of Figure 2, and showing how an electronic device is held within the packaging volume.

### DETAILED DESCRIPTION

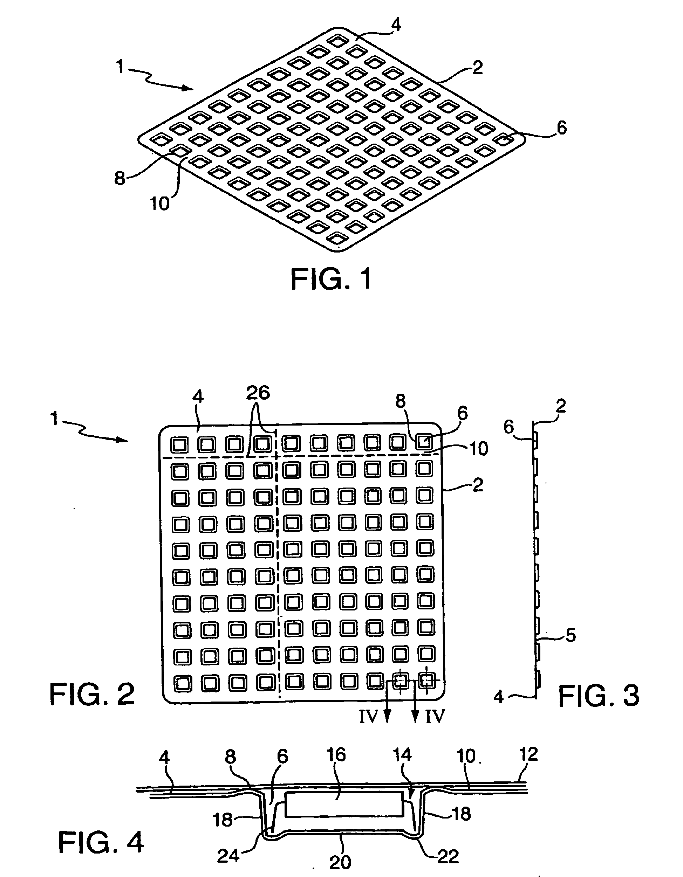

Figures 1 and 2 show an electronics packaging system 1 having a tray 2 formed of plastic sheet material, which in this example has antistatic properties. As shown in Figure 3, the sheet is formed from a thin material having opposite first and second surfaces 4, 5. The first surface 4 has a regular array of individual recesses 6. Each recess 6 has a rounded square outline and is bounded by a rim 8.

As shown in Figure 4, the rim 8 rises above a flat portion 10 of the first surface 4 that extends continuously around each recess 6. It is not, however, necessary that the rim 8 is higher than the surrounding surface 10, and the surrounding flat surface 10 could extend continuously up to the rim at the edge of each recess 6.

A coversheet of fabric 12 extends over the first side 4 of the tray 2 and across the rims 8 around each of the recesses 6. In this example, the fabric also has antistatic properties. The coversheet 12 is bonded to the tray 2 to provide individual packaging volumes 14 for an electronic device 16.

Each recess 6 is surrounded by four side walls 18 which slope down into the recess at a near-vertical orientation. Each recess 6 has a flat central portion 20. A groove 22 extends around the base of each side wall 18 between the side walls 18 and the flat base 20.

As can be seen from Figure 4, the packaging volume 14 is an appropriate size for a semi conductor device 16 which is securely held within the packaging volume. The electronic device 16 has legs 24, the groove 22 being orientated so that the legs 24 are located in the groove 22.

The tray 2 can be provided with one or more lines of perforations 26, two of which are shown in Figure 2. Preferably, perforations 26 separate each one of the recesses 6 so that in use the tray 2 can be subdivided to provide smaller quantities of electronic components 16 as required.

The perforations 26 extend through the sheet, and may optionally also perforate the coversheet 12.

When a user wishes to release one of the electronic components 16, he may pull back the coversheet 12, and to help this the coversheet 12 is not bonded to the tray sheet material 4 in the flat regions 10 surrounding each recess 6. A user can then more easily peel back the coversheet 12 to release the electronic device 16.

In this example, the antistatic fabric is a static dissipative coated fabric sold as ITP-150 Tyvek (Registered Trade Mark), type 1073B. This is a heat sealable material which can be bonded to the underlying plastic tray by a heating sealing process. If anti-static properties are not required this could be another fabric without an electro-static discharge (esd) related pre-treatment.

Alternatively, it would be possible to use an adhesive between the coversheet 12 and tray sheet material 4 in order to bond these together.

The tray 2 itself, is also made from an antistatic plastic composition. In this example, the preferred composition is an APET plastic material. Future materials may or may not have static related properties depending on the components being inserted into the tray.

The shape of the tray 2 may be any convenient shape, and is not limited to the square outline shown in the drawings. For example, the tray 2 could be an extended length of plastic sheet material, and may be provided in roll form, for example on a dispensing spool or within a box dispenser.

In production, the sheet material 12 may be bonded to the tray sheet material 4 in a continuous process in which an extended length of the coversheet material 12 is bonded to a corresponding length of the tray sheet material 4, after insertion of electronic components 16 in each of the recesses 6.

The size of the recesses 6 may be varied in order to accommodate different sized electronic components 16. It would also be possible to provide a tray having a range of different recess sizes as well as containing different size electronic components 16. This may be convenient when a range of different electronic components are expected to be needed in one application.

The invention therefore provides a convenient and reliable way of packaging electronic component, particularly static sensitive, electro-mechanical and passive electronic components.

## Claims

1. An electronics packaging system (1) for electronic components, comprising:
- a tray (2) formed of plastic sheet material, said sheet having opposite first and second surfaces (4,5) and having a plurality of individual recesses (6) formed in the first surface (4) thereof, each recess having a rim (8) that extends around the recess and each recess (6) being surrounded by a planar region (10) of said first surface (4), and the rim (8) projecting above said region (10); and
- a coversheet (12) of fabric which extends over said first surface of the tray (2) and across the rims (8) around said recesses, said coversheet (12) being bonded to the tray (2) to provide an individual packaging volume (14) for an electronic device (16) between each recess and said coversheet; wherein
said coversheet (12) is bonded to the first surface (4) at each rim (8), but not in at least a portion of said surrounding planar region (10),

2. An electronics packaging system (1) as claimed in Claim 1, in which the coversheet (12) is an antistatic coversheet.

3. An electronics packaging system (1) as claimed in Claim 1, in which the tray (2) has antistatic properties.

4. An electronics packaging system (1) as claimed in any preceding cairn, in which the surrounding planar region (10) is provided with one or more lines of weakness (26) so that a user can tear or break along said lines to separate one or more of said packaging volumes (14) from one or more other packaging volumes.

5. An electronics packaging system (1) as claimed in Claim 4, in which said lines of weakness include a perforation (26) in at least the plastic sheet material, said perforation not extending into said individual packaging volume (14).

6. An electronics packaging system (1) as claimed in Claim 4, in which said lines of weakness include a local thinning in at least the plastic sheet material, said thinning not extending into said individual packaging volume (14).

7. An electronics packaging system (1) as claimed in any preceding claim, comprising additionally an electronic chip (16) held within said packaging volume, said chip having projecting connection pins (24) which extend from one side of a body of the chip, said pins being seated within a groove (22) provided in a base (20) of the recess such that the pins extend away from said coversheet (12).

8. An electronics packaging system (1) as claimed in Claim 7, in which each recess (6) includes side walls (18), the groove (22) in the recess extending around the base of said side walls, and said side walls having a clearance with said chip in the recess which maintains the seated location of said pins (24) within the groove (22).

## Patentansprüche

1. Ein elektronisches Verpackungssystem (1) für elektronische Komponenten umfassend:
- einen aus einem Kunststofffolienmaterial gebildeten Boden (2), wobei die Folie sich gegenüberliegende erste und zweite Oberflächen (4, 5) und eine Vielzahl von individuellen, in der ersten Oberfläche (4) gebildeten Ausnehmungen (6) aufweist, wobei jede Vertiefung einen Rand (8) aufweist, der sich um die Ausnehmung herum erstreckt, und jede Ausnehmung (6) von einem planaren Bereich (10) der ersten Oberfläche (4) umgeben ist, und die Kante (8) über den Bereich (10) hervorsteht,
- eine Abdeckfolie (12) aus einem Gewebe, welche sich über die erste Oberfläche des Bodens (2) und über die Kanten (8) um die Ausnehmungen herum erstreckt, wobei die Abdeckfolie (12) mit dem Boden (2) verbunden ist, um ein individuelles Verpackungsvolumen (14) für eine elektronische Vorrichtung (16) zwischen jeder Ausnehmung und der Abdeckfolie bereitzustellen,
- wobei die Abdeckfolie (12) mit der ersten Oberfläche (4) an jeder Kante (8) verbunden ist, aber zumindest nicht in einem Teil des umgebenden ebenen Bereiches (10).

2. Ein elektronisches Verpackungssystem (1) gemäß Anspruch 1, in welchem die Abdeckfolie (12) eine antistatische Abdeckfolie ist.

3. Ein elektronisches Verpackungssystem (1) gemäß Anspruch 1, in welchem der Boden (2) antistatische Eigenschaften aufweist.

4. Ein elektronisches Verpackungssystem (1) gemäß einem der vorhergehenden Ansprüche, in welchem der umgebende planare Bereich (10) mit einer oder mehreren Schwächungslinien (26) ausgestattet ist, so dass ein Anwender entlang der Linien aufreißen oder aufbrechen kann, um ein oder mehrere der Verpackungsvolumen (14) von einem oder mehreren der anderen Verpackungsvolumen zu trennen.

5. Ein elektronisches Verpackungssystem (1) gemäß Anspruch 4, in welchem die Schwächungslinien eine Perforation (26) zumindest in dem Kunststofffolienmaterial enthält, wobei die Perforation sich nicht in die individuellen Verpackungsvolumina (14) erstreckt.

6. Ein elektronisches Verpackungssystem (1) gemäß Anspruch 4, in welchem die Schwächungslinien eine lokale Verdünnung zumindest in dem Kunststofffolienmaterial enthält, wobei die Verdünnung sich nicht in die individuellen Verpackungsvolumina (14) erstreckt.

7. Ein elektronisches Verpackungssystem (1) gemäß einem der vorhergehenden Ansprüche, zusätzlich umfassend einen in dem Verpackungsvolumen gehaltenen elektronischen Chip (16), wobei der Chip vorstehende Verbindungsanschlüsse (24) aufweist, welche sich von einer Seite eines Körpers des Chips erstrecken, wobei die Anschlüsse innerhalb einer in dem Boden (20) der Ausnehmung vorgesehenen Kerbe (22) bereitgestellt werden, so dass sich die Anschlüsse weg von der Abdeckfolie (12) erstrecken.

8. Ein elektronisches Verpackungssystem (1) gemäß Anspruch 7, in welchem jede Ausnehmung (6) Seitenwände (18) enthält, wobei die Kerbe (22) sich in der Ausnehmung um den Boden der Seitenwände erstreckt, und die Seitenwände einen Abstand zu dem Chip in der Ausnehmung aufweisen, welcher die gesetzte Anordnung der Anschlüsse (24) innerhalb der Kerbe (22) aufrecht erhält.

## Revendications

1. Système d'emballage de composants électroniques (1) pour des composants électroniques, comprenant :
- un plateau (2) formé d'un matériau en feuille de plastique, ladite feuille ayant des première et seconde surfaces opposées (4, 5) et ayant une pluralité d'évidements (6) individuels formés dans la première surface (4) de ce dernier, chaque évidement ayant un rebord (8) qui s'étend autour de l'évidement et chaque évidement (6) étant entouré par une région plane (10) de ladite première surface (4), et le rebord (8) étant en saillie au-dessus de ladite région (10) ;
- une feuille de couverture (12) en tissu qui s'étend sur ladite première surface du plateau (2) et par-dessus les rebords (8) autour desdits évidements, ladite feuille de couverture (12) étant collée au plateau (2) pour fournir un volume d'emballage individuel (14) pour un composant électronique (16) entre chaque évidement et ladite feuille de couverture ; où
ladite feuille de couverture (12) est collée à la première surface (4) à chaque rebord (8), mais pas à au moins une portion de ladite région plane les entourant (10).

2. Système d'emballage de composants électroniques (1) selon la revendication 1, dans lequel la feuille de couverture (12) est une feuille de couverture antistatique.

3. Système d'emballage de composants électroniques (1) selon la revendication 1, dans lequel le plateau (2) a des propriétés antistatiques.

4. Système d'emballage de composants électroniques (1) selon l'une quelconque des revendications précédentes, dans lequel la région plane entourant les évidements (10) est pourvue d'une ou plusieurs lignes de faiblesse (26) de sorte qu'un utilisateur peut séparer un ou plusieurs desdits volumes d'emballage (14) d'un ou plusieurs autres volumes d'emballage par déchirement ou rupture le long desdites lignes.

5. Système d'emballage de composants électroniques (1) selon la revendication 4, dans lequel lesdites lignes de faiblesse comprennent une perforation (26) dans au moins le matériau en feuille de plastique, ladite perforation ne s'étendant pas dans ledit volume d'emballage individuel (14).

6. Système d'emballage de composants électroniques (1) selon la revendication 4, dans lequel lesdites lignes de perforation comprennent un affinement local dans au moins le matériau en feuille de plastique, ledit affinement ne s'étendant pas dans ledit volume d'emballage individuel (14).

7. Système d'emballage de composants électroniques (1) selon l'une quelconque des revendications précédentes, comprenant en outre une puce électronique (16) contenue dans ledit volume d'emballage, ladite puce ayant des pinces de contact (24) en saillie qui s'étendent d'un côté d'un corps de la puce, lesdites pinces étant assises dans une rainure (22) pourvue dans une base (20) de l'évidement de sorte que les pinces s'étendent en éloignement de ladite feuille de couverture (12).

8. Système d'emballage de composants électroniques (1) selon la revendication 7, dans lequel chaque évidement (6) comprend des parois latérales (18), la rainure (22) dans l'évidement s'étendant autour de la base desdites parois latérales, et lesdites parois latérales ayant un débattement avec ladite puce dans l'évidement qui maintient la position assise desdites pinces (24) à l'intérieur de la rainure (22).
